# FASCICULE DE BREVET EUROPEEN

(11) **EP 4 170 434 B1**
(45) Date de publication et mention de la délivrance du brevet: **01.10.2025**
(21) Numéro de dépôt: 21207803.4
(22) Date de dépôt: 11.11.2021
(51) Int. Cl.: G04B 39/00, G04D 3/00, G04B 19/12, G04B 37/22, G04B 45/00

(54) **PROCEDE DE DECORATION D'UN SUBSTRAT**
VERFAHREN ZUR DEKORATION EINES SUBSTRATS
METHOD FOR DECORATING A SUBSTRATE

(30) Priorité: 25.10.2021 EP 21204426
(43) Date de publication de la demande: 26.04.2023
(73) Titulaire: Comadur SA, 2400 Le Locle (CH)
(72) Inventeur: LINTYMER, Jan, 25620 Mamirolle (FR); BOULMAY, Alexis, 25800 Valdahon (FR)
(74) Mandataire: ICB SA

(56) Documents cités:
- EP-A1- 2 871 534
- EP-A1- 3 035 129
- EP-A1- 3 336 614
- EP-A1- 3 339 980
- EP-A1- 3 379 342
- EP-A1- 3 489 761
- EP-A1- 3 772 673
- EP-A1- 3 907 564
- EP-A2- 1 895 370
- EP-B1- 2 798 413
- WO-A1-2013/014515
- CH-A1- 711 851
- CH-A1- 713 871
- CH-A1- 716 196
- CH-B1- 713 407
- CH-B1- 716 774
- CH-B1- 719 259
- JP-A- 2023 072 671
- US-A1- 2016 176 228
- US-B2- 11 550 261

## Description

### Domaine technique de l'invention

La présente invention concerne un procédé de décoration d'un substrat. La présente invention concerne en particulier un procédé permettant de réaliser un décor mat ou satiné sur un substrat poli, notamment un cadran d'une montre, et plus généralement sur tout élément d'habillage d'une pièce d'horlogerie tel qu'une lunette, une carrure, un fond, un maillon de bracelet ou bien encore une glace. La présente invention s'applique également à tout type d'article de bijouterie, notamment les bracelets.

### Arrière-plan technologique

Une technique actuellement utilisée pour impartir à certaines zones d'un substrat tel qu'un cadran de montre un aspect visuel différent de celui du reste de la surface du substrat consiste à exposer ces zones par exemple à l'action d'un faisceau laser, puis à métalliser ces zones. L'opération de métallisation est difficile à mettre en œuvre, notamment parce que les zones gravées au moyen du faisceau laser qui sont à métalliser sont souvent de faibles dimensions et qu'il est donc difficile de déposer avec précision les couches de métallisation sur ces zones. Il arrive en effet que les couches de métallisation excèdent les dimensions des zones du substrat traitées au moyen du faisceau laser sur lesquelles ces métallisations ont été déposées, et empiètent sur les zones voisines. Inversement, il peut aussi arriver que les couches de métallisation ne recouvrent pas complètement les zones du substrat qui doivent être métallisées, de sorte que ces zones restent visibles sous les couches de métallisation. Dans les deux cas, le rendu final du substrat ainsi traité n'est pas satisfaisant, et une part non négligeable de ces substrats doit être mise au rebut. Un autre inconvénient de cette technique est que le substrat est altéré par l'opération de gravure laser. existe encore les documents EP3339980A1,CH713871 A1 et EP3035129A1 qui divulguent des procédés de décoration similaires.

### Résumé de l'invention

La présente invention a pour but de remédier aux problèmes mentionnés ci-dessus ainsi qu'à d'autres encore en proposant un procédé permettant notamment de décorer un substrat avec précision.

À cet effet, la présente invention concerne un procédé de décoration d'un substrat selon la revendication 1.

Selon une forme spéciale d'exécution de l'invention, les cavités sont de profondeurs différentes.

Selon une autre forme spéciale d'exécution de l'invention, certaines au moins des cavités créées dans la couche de matériau sacrificiel traversent cette couche de matériau sacrificiel jusqu'au substrat.

Selon encore une autre forme spéciale d'exécution de l'invention, la couche de matériau sacrificiel est déposée à la surface du substrat par dépôt physique en phase vapeur, par dépôt chimique en phase vapeur ou bien par électrodéposition lorsque le substrat est conducteur de l'électricité.

Selon encore une autre forme spéciale d'exécution de l'invention, la couche de matériau sacrificiel est réalisée au moyen d'un ou de plusieurs matériaux métalliques ou bien des oxydes, nitrures, carbures ou carbo-oxynitrures de ce ou ces matériaux métalliques.

Selon encore une autre forme spéciale d'exécution de l'invention, le matériau métallique est choisi dans le groupe formé par le chrome, le zirconium, le titane et l'aluminium.

Selon encore une autre forme spéciale d'exécution de l'invention, la couche de matériau sacrificiel a une épaisseur comprise entre 100 nm et 10 µm.

Selon encore une autre forme spéciale d'exécution de l'invention, la couche de matériau sacrificiel a une épaisseur comprise entre 500 nm et 2 µm.

Selon encore une autre forme spéciale d'exécution de l'invention, les cavités dans la couche de matériau sacrificiel sont créées par attaque chimique en voie humide ou en voie sèche, par ablation laser ou bien par photolithographie.

Selon encore une autre forme spéciale d'exécution de l'invention, l'attaque chimique en voie humide ou en voie sèche affecte toute la surface de la couche de matériau sacrificiel ou bien s'opère à travers les ouvertures d'un masque posé sur la couche de matériau sacrificiel et dont les contours correspondent au motif décoratif ou technique que l'on veut faire apparaître dans la couche de matériau sacrificiel.

Selon encore une autre forme spéciale d'exécution de l'invention, la photolithographie consiste à créer les cavités dans la couche de matériau sacrificiel directement par ablation au moyen d'un faisceau laser ou au moyen d'un rayonnement lumineux à travers les ouvertures d'un masque posé sur cette couche de matériau sacrificiel et dont les contours correspondent au motif décoratif ou technique que l'on veut faire apparaître dans la couche de matériau sacrificiel.

Selon l'invention après structuration de la couche de matériau sacrificiel pour y créer les cavités, et avant élimination de la couche de matériau sacrificiel sur toute la surface du substrat sauf à l'endroit où le motif est prévu, on dépose sur la couche de matériau sacrificiel au moins une couche supplémentaire de finition.

Selon encore une autre forme spéciale d'exécution de l'invention, la couche supplémentaire de finition est réalisée au moyen d'un ou de plusieurs matériaux métalliques ou bien des oxydes, nitrures, carbures ou carbo-oxynitrures de ces matériaux métalliques.

Selon encore une autre forme spéciale d'exécution de l'invention, le matériau métallique dans lequel la couche supplémentaire de finition est réalisée est choisi dans le groupe formé par le chrome, le zirconium, l'or, le titane et l'aluminium.

Selon encore une autre forme spéciale d'exécution de l'invention, après structuration de la couche de matériau sacrificiel et éventuellement dépôt de la couche supplémentaire de finition, on effectue les étapes suivantes :
- déposer sur la couche de matériau sacrificiel éventuellement revêtue de la couche supplémentaire de finition une couche d'une résine photosensible ;
- exposer la couche de résine photosensible directement à l'action d'un faisceau laser ou bien à un rayonnement lumineux sélectivement aux endroits correspondant au motif décoratif ou technique que l'on veut faire apparaître dans la couche de matériau sacrificiel ;
- éliminer la couche de résine photosensible et la couche de matériau sacrificiel éventuellement recouverte de la couche supplémentaire de finition aux endroits où la couche de résine photosensible n'a pas été insolée ;
- éliminer la couche de résine photosensible qui subsiste aux endroits où la couche de matériau sacrificiel doit rester.

Selon encore une autre forme spéciale d'exécution de l'invention, le substrat est un élément d'habillage pour une boîte de montre ou pour un article de bijouterie.

Selon encore une autre forme spéciale d'exécution de l'invention, le substrat est un pont, une platine, une lunette, une carrure, une glace, un cadran, un fond ou un maillon de bracelet.

Selon encore une autre forme spéciale d'exécution de l'invention, le substrat présente un aspect poli.

Grâce à ces caractéristiques, la présente invention procure un procédé permettant notamment de décorer un substrat sans modifier ni altérer l'état de surface de ce substrat. On comprend en particulier qu'étant donné que le procédé selon l'invention consiste à structurer un motif décoratif ou technique non pas directement dans le substrat mais dans une couche de matériau déposée sur ce substrat, on n'est pas tributaire de la nature parfois extrêmement dure du matériau dans lequel est réalisé le substrat, et on dispose d'une large gamme de matériaux pour réaliser, à la surface du substrat, la couche dans laquelle on va former le motif. Par ailleurs, par le jeu des réflexions multiples de la lumière ambiante à l'intérieur des cavités qui forment le motif, ce motif présente un aspect mat à satiné qui se distingue remarquablement bien du reste de la surface du substrat, tout particulièrement lorsque le substrat présente un état de surface poli. On notera également que, quel que soit le mode de mise en œuvre considéré, le procédé selon l'invention permet de s'affranchir des problèmes de précision de positionnement que l'on rencontre fréquemment lorsque l'on souhaite décorer des substrats tels que des cadrans de montre ou des glaces de montre.

### Brève description des figures

D'autres caractéristiques et avantages de la présente invention ressortiront plus clairement de la description détaillée qui suit d'un mode de réalisation du procédé de décoration selon l'invention, cet exemple étant donné à titre purement illustratif et non limitatif seulement en liaison avec le dessin annexé sur lequel :
- la figure 1 est une vue en coupe d'un substrat sur une surface duquel est déposée une couche de matériau sacrificiel ;
- la figure 2 illustre la réalisation de cavités dans la couche de matériau sacrificiel par trempage du substrat dans un bain d'attaque chimique ;
- la figure 3 est une vue analogue à celle de la figure 1 qui illustre l'étape de structuration de la couche de matériau sacrificiel de sorte à créer dans cette couche de matériau sacrificiel une pluralité de cavités pour former un motif décoratif ou technique ;
- la figure 4 est une vue analogue à celle de la figure 3 qui illustre l'étape de dépôt d'une couche supplémentaire de finition sur la couche de matériau sacrificiel après structuration de cette couche de matériau sacrificiel ;
- la figure 5 est une vue analogue à celle de la figure 4 qui illustre l'étape de dépôt d'une couche de résine photosensible sur la couche supplémentaire de finition ;
- la figure 6 est une vue analogue à celle de la figure 5 qui illustre l'élimination de la couche de résine photosensible dans les zones où cette couche de résine photosensible n'a pas été insolée ;
- la figure 7 est une vue analogue à celle de la figure 6 qui illustre l'étape d'élimination de la couche de matériau sacrificiel et de la couche de finition dans les zones où la couche de résine photosensible n'a pas été insolée ;
- la figure 8 est une vue analogue à celle de la figure 7 qui illustre l'élimination de la couche de résine photosensible résiduelle qui a été insolée aux endroits où la couche de matériau sacrificiel a été structurée et où elle doit rester pour former le motif décoratif ;
- la figure 9 illustre schématiquement un substrat revêtu d'une couche de matériau sacrificiel sur laquelle est déposée une première couche de résine photosensible ;
- la figure 10 illustre la couche de résine photosensible qui est sélectivement insolée pour créer des cavités ;
- la figure 11 illustre le développement de la couche de résine photosensible de façon que des premières zones non insolées soient éliminées et que ne subsistent que des secondes zones qui ont été exposées à la lumière ;
- la figure 12 illustre le cas où, après avoir créé, dans la couche de matériau sacrificiel, des cavités destinées à former le motif, on recouvre la couche de matériau sacrificiel d'au moins une couche supplémentaire de finition ;
- la figure 13 est une vue analogue à celle de la figure 12 qui illustre le dépôt, sur la couche supplémentaire de finition, d'une seconde couche de résine photosensible dans laquelle on distingue des premières zones qui n'ont pas été exposées et des secondes zones qui ont été insolées directement au moyen d'un faisceau laser ou à travers un masque et qui correspondent au motif que l'on veut former dans la couche de matériau sacrificiel ;
- la figure 14 est une vue analogue à celle de la figure 13 qui illustre le développement de la couche de résine photosensible après insolation de cette dernière directement au moyen d'un faisceau laser ou à travers un masque, les premières zones non-exposées étant éliminées et ne subsistant que les secondes zones qui ont été exposées à la lumière et qui correspondent au motif recherché ;
- la figure 15 est une vue analogue à celle de la figure 14 qui illustre l'élimination des parties de la couche de résine photosensible qui ont été exposées à la lumière.

### Description détaillée de l'invention

La présente invention procède de l'idée générale inventive qui consiste à réaliser un motif décoratif ou technique à la surface d'un substrat sans modifier ou altérer l'état de surface de ce substrat. A cette fin, la présente invention enseigne de déposer à la surface du substrat une couche de matériau dit sacrificiel dans laquelle on va réaliser une pluralité de cavités plus ou moins profondes selon un schéma qui correspond à la forme du motif décoratif ou technique recherché. Eventuellement revêtues d'une ou de plusieurs couches supplémentaires de finition pour parfaire l'état de surface et ajuster la couleur de la couche de matériau sacrificiel sous-jacente, ces groupes de cavités vont, par le jeu des réflexions multiples de la lumière ambiante incidente qui pénètre dans ces cavités, former le motif recherché qui sera perceptible à l'œil nu. En outre, selon le nombre et la profondeur de ces cavités, le motif résultant va présenter un aspect mat à satiné qui va nettement se distinguer de la surface environnante du substrat sur lequel ce motif a été structuré, en particulier lorsque le substrat présente un état de surface poli.

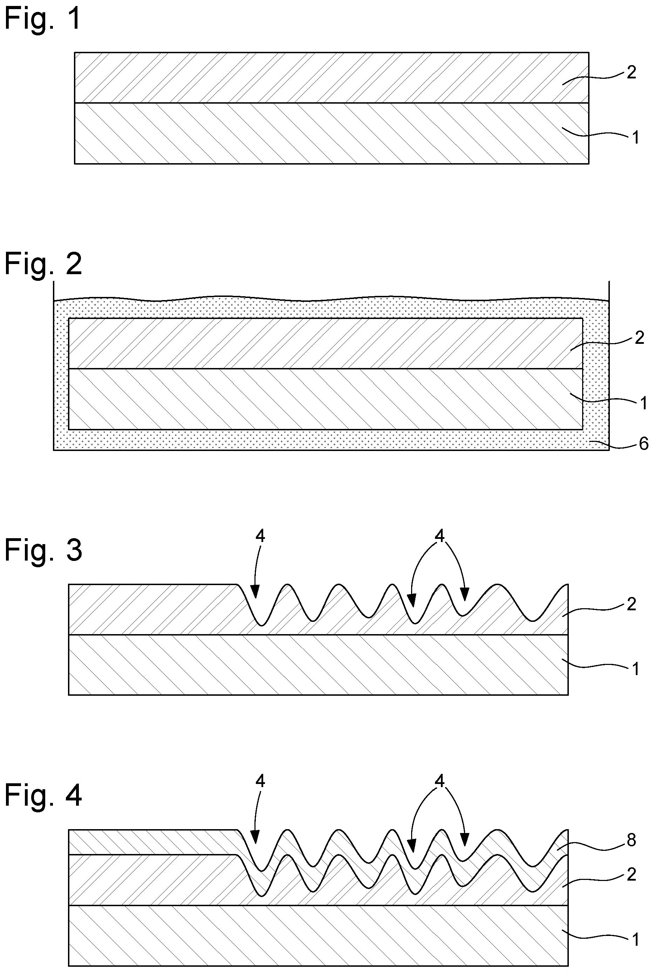

Désigné dans son ensemble par la référence numérique générale 1, un substrat est vu en coupe sur la figure 1. De préférence mais non obligatoirement, ce substrat 1 présente un état de surface poli. Ce substrat 1 peut être tout type de pièce pour l'horlogerie tel que, non limitativement, un pont, une platine, une lunette, une carrure, une glace, un cadran, un fond ou bien encore un maillon de bracelet. Il peut également s'agir d'un article de bijouterie tel qu'un bracelet, une bague ou un médaillon. Plus généralement, un substrat au sens de la présente demande de brevet s'entend de toute pièce support permettant la mise en œuvre du procédé selon l'invention.

Conformément à l'invention et comme visible sur la figure 1, le substrat est recouvert d'une couche de matériau sacrificiel 2. Cette couche de matériau sacrificiel 2 est réalisée au moyen d'un matériau métallique préférentiellement choisi dans le groupe formé par le chrome, le nitrure de chrome, l'oxynitrure de chrome, le zirconium, le nitrure de zirconium et l'oxynitrure de zirconium. Cette couche de matériau sacrificiel 2 a une épaisseur typiquement comprise entre 100 nm et 10 µm et, de manière préférée, comprise entre 500 nm et 2 µm. Bien entendu, l'épaisseur de la couche de matériau sacrificiel 2 peut excéder ces valeurs. La couche de matériau sacrificiel 2 peut également résulter de la combinaison d'au moins deux matériaux métalliques différents ou bien des oxydes, nitrures, carbures ou carbo-oxynitrures de ces matériaux métalliques.

La couche de matériau sacrificiel 2 est déposée à la surface du substrat 1 par toute technique appropriée telle que dépôt physique en phase vapeur, dépôt chimique en phase vapeur ou bien électrodéposition lorsque le substrat 1 est conducteur de l'électricité.

Après dépôt de la couche de matériau sacrificiel 2 à la surface du substrat 1, cette couche de matériau sacrificiel 2 est structurée de sorte à y créer une pluralité de cavités 4.

La structuration des cavités 4 dans la couche de matériau sacrificiel 2 peut être faite par toute technique appropriée. A titre d'exemple illustré à la figure 2, le substrat 1 revêtu de la couche de matériau sacrificiel 2 est plongé dans un bain 6 d'attaque chimique, certaines zones de la couche de matériau sacrificiel 2 pouvant le cas échéant être masquées pour ne pas être soumises à l'action du bain 6. De la sorte, la surface de la couche de matériau sacrificiel 2 va être soumise à l'action corrosive du bain 6. Cette attaque chimique n'étant pas parfaitement uniforme et ses effets dépendant en particulier du temps durant lequel le substrat 1 est maintenu dans le bain 6, les cavités 4 formées dans la couche de matériau sacrificiel 2 ne seront pas toutes de la même profondeur.

Comme visible sur la figure 3, une fois le substrat 1 retiré du bain 6 d'attaque chimique, des cavités 4 de profondeurs différentes dont certaines peuvent même traverser la couche de matériau sacrificiel 2 de part en part jusqu'au substrat 1 sont formées sur la totalité de la surface de la couche de matériau sacrificiel 2 qui a été exposée à l'attaque chimique.

Selon une autre forme d'exécution de l'invention non représentée, au lieu d'une attaque de la couche de matériau sacrificiel 2 par voie humide, on peut également procéder à une attaque de cette couche de matériau sacrificiel 2 par voie sèche, en plaçant le substrat 1 dans une atmosphère gazeuse corrosive pour créer les cavités 4.

Selon encore une autre forme d'exécution de l'invention non représentée, au lieu d'une attaque de la couche de matériau sacrificiel 2 par voie chimique, il est également possible de structurer cette couche de matériau sacrificiel 2 par ablation au moyen d'un faisceau laser.

Après structuration des cavités 4 dans la couche de matériau sacrificiel 2, cette dernière peut, à titre préféré mais non obligatoire, être revêtue d'au moins une couche supplémentaire de finition 8 comme montré à la figure 4. Cette couche supplémentaire de finition 8 peut être déposée, par exemple, par dépôt physique ou chimique en phase vapeur. Cette couche supplémentaire de finition 8 peut être réalisée dans le même matériau que la couche de matériau sacrificiel 2. Cette couche supplémentaire de finition 8 est réalisée au moyen de tout matériau métallique, oxynitrure de matériau métallique ou alliage de matériaux métalliques ; elle peut notamment être réalisée en or, chrome, zirconium, titane ou aluminium. Cette au moins une couche supplémentaire de finition 8 sert à parfaire l'état de surface et à ajuster la couleur de la couche de matériau sacrificiel 2 sous-jacente.

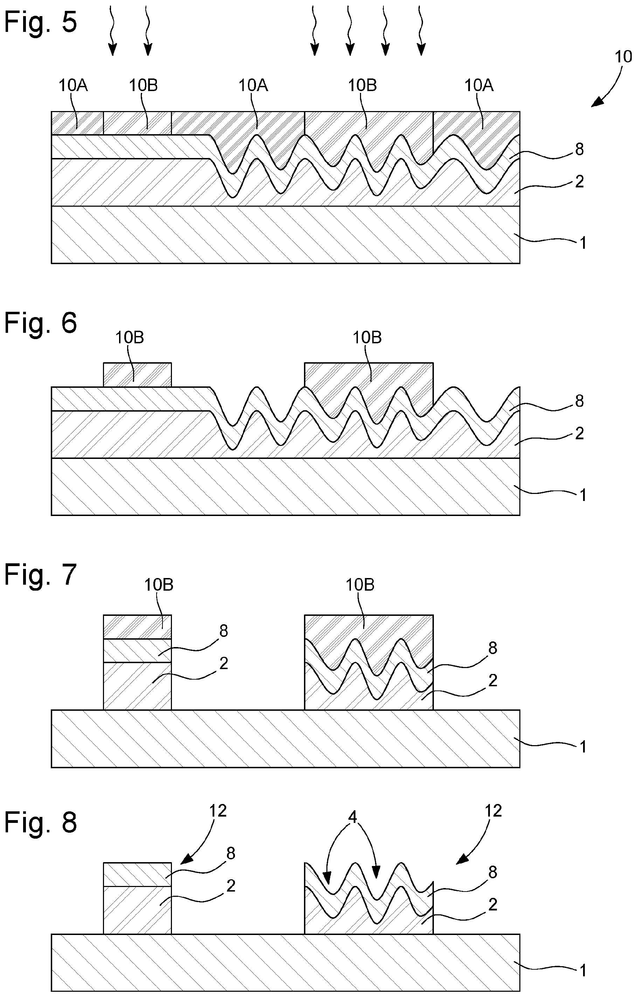

Comme illustré sur la figure 5, après dépôt de la couche supplémentaire de finition 8, on dépose sur cette couche supplémentaire de finition 8 une couche de résine photosensible 10. Cette couche de résine photosensible 10 est ensuite sélectivement insolée au moyen d'un rayonnement lumineux aux endroits qui correspondent au motif 12 décoratif ou technique que l'on veut faire apparaître dans la couche de matériau sacrificiel 2. Dans la couche de résine photosensible 10, on distingue ainsi des premières zones 10A qui n'ont pas été exposées au rayonnement lumineux et des secondes zones 10B qui ont été exposées au rayonnement lumineux et qui correspondent au motif 12 recherché. La couche de résine photosensible 10 peut être sélectivement insolée par exemple directement au moyen d'un faisceau laser dont les déplacements sont commandés par un ordinateur, ou bien au moyen d'un rayonnement lumineux, par exemple ultraviolet, à travers un masque dont les ouvertures correspondent aux zones de la couche de matériau sacrificiel 2 que l'on veut conserver pour créer le motif 12 décoratif ou technique que l'on veut faire apparaître à la surface du substrat 1.

Après insolation sélective de la couche de résine photosensible 10, cette couche de résine photosensible 10 est développée de façon que les premières zones 10A non-exposées au rayonnement ultraviolet soient éliminées et que ne subsistent que les secondes zones 10B qui ont été exposées à la lumière et qui correspondent au motif 12 recherché (voir figure 6).

Puis, comme illustré à la figure 7, les parties de la couche de matériau sacrificiel 2 et de la couche supplémentaire de finition 8 non recouvertes par la couche de résine photosensible 10 sont éliminées jusqu'à mettre à nouveau le substrat 1 à nu.

Finalement (figure 8), les secondes zones 10B de la couche de résine photosensible 10 qui ont été exposées au rayonnement ultraviolet sont éliminées à leur tour.

Les cavités 4 formées dans les zones de la couche de matériau sacrificiel 2 qui subsistent à la surface du substrat 1 ne sont pas toutes de même profondeur de sorte que, par le jeu des réflexions multiples de la lumière incidente qui pénètre dans ces cavités 4, le motif 12 décoratif ou technique formé par le réseau de cavités 4 va présenter un aspect mat ou satiné qui se détachera distinctement du reste de la surface du substrat 1, en particulier lorsque ce dernier présente un état de surface poli. En effet, les motifs 12 décoratifs ou techniques formés par la combinaison des cavités 4 présentent, en fonction de la profondeur de ces cavités 4, un aspect mat ou satiné qui crée un contraste visuel remarquable avec l'éclat du reste de la surface du substrat 1 non recouvert par la couche de matériau sacrificiel 2.

On notera également que, de préférence, les cavités 4 sont structurées dans la couche de matériau sacrificiel 2 après exposition de la surface de la couche de matériau sacrificiel 2 par exemple à l'action corrosive du bain 6 de façon à former un réseau de plus grandes dimensions que les dimensions du motif 12 final recherché. Par suite, pour le bon positionnement du motif 12 relativement au substrat 1, on dispose d'une certaine marge pour le bon alignement de ce substrat 1 par rapport au masque au travers duquel la couche de résine photosensible est insolée, ce qui est très avantageux.

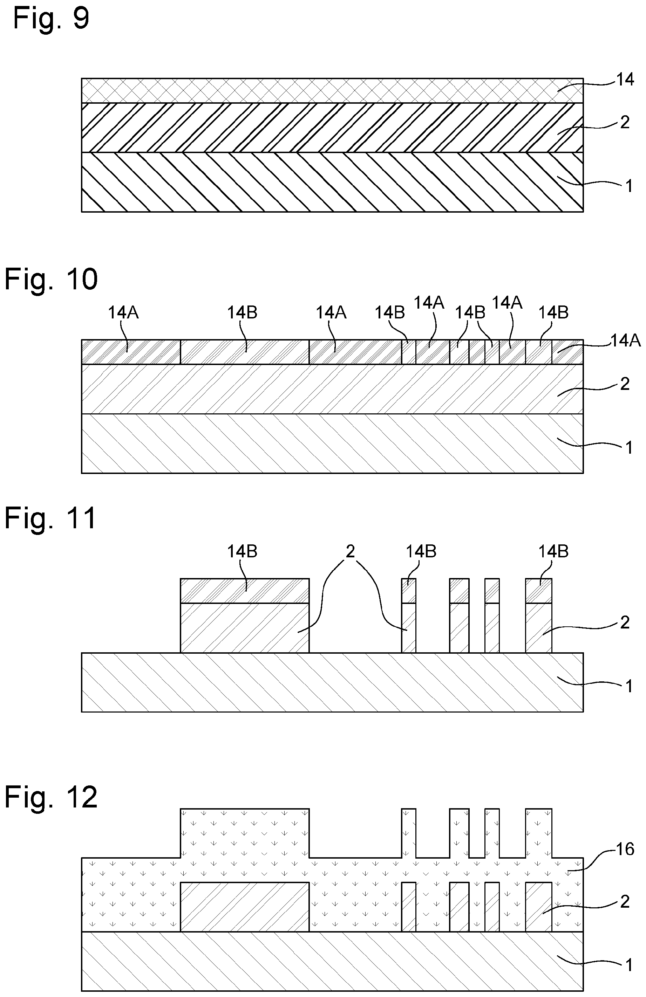

Une autre forme d'exécution de l'invention est illustrée aux figures 9 à 15. Sur la figure 9, le substrat 1 est revêtu d'une couche de matériau sacrificiel 2 sur laquelle est déposée une première couche de résine photosensible 14.

Comme visible sur la figure 10, cette couche de résine photosensible 14 est ensuite sélectivement insolée pour créer les cavités 4. Cette insolation sélective de la couche de résine photosensible 14 peut être effectuée par exemple directement au moyen d'un faisceau laser ou à travers un masque dont les ouvertures correspondent aux zones de la couche de matériau sacrificiel 2 que l'on veut conserver. Dans la couche de résine photosensible 14, on distingue ainsi des premières zones 14A qui n'ont pas été exposées à l'éclairage sélectif, et des secondes zones 14B qui ont été sélectivement éclairées et qui correspondent aux parties de la couche de matériau sacrificiel 2 que l'on doit conserver.

Après insolation sélective, la couche de résine photosensible 14 est développée de façon que les premières zones 14A soient éliminées et que ne subsistent que les secondes zones 14B qui ont été exposées à la lumière comme cela est visible sur la figure 11. Puis, les parties de la couche de matériau sacrificiel 2 non recouvertes par la couche de résine photosensible 14 sont éliminées par attaque chimique jusqu'à mettre à nouveau le substrat 1 à nu. Finalement, les secondes zones 14B de la couche de résine photosensible 14 qui ont été exposées à l'éclairage sélectif sont éliminées à leur tour, de sorte qu'il ne subsiste que les parties de la couche de matériau sacrificiel 2 dans lesquelles ont été structurées les cavités 4.

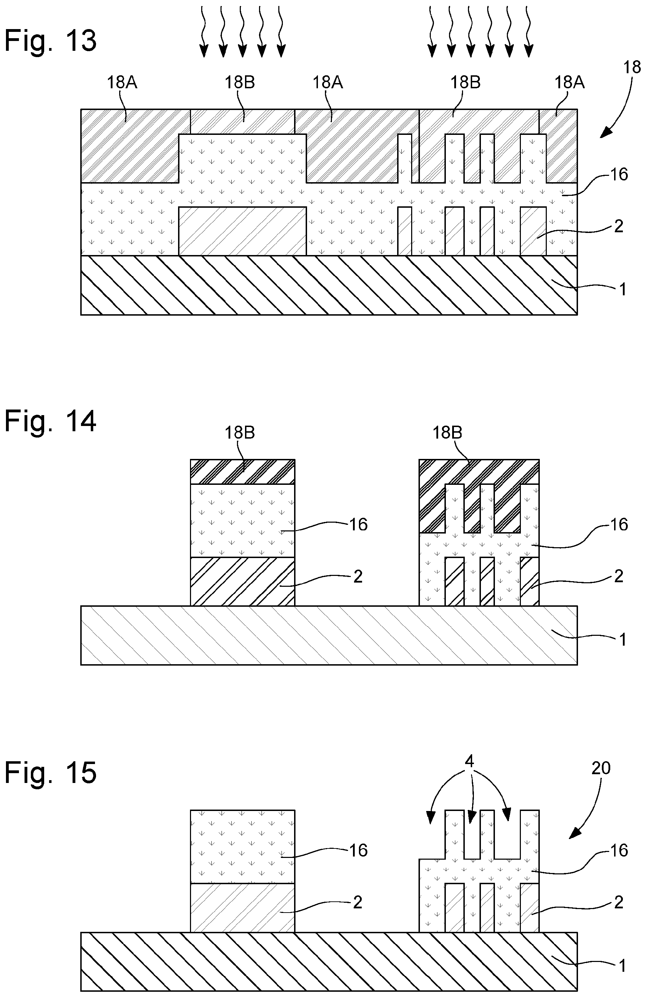

Après quoi, comme schématiquement illustré à la figure 12, le substrat 1 est recouvert d'au moins une couche supplémentaire de finition 16, elle-même recouverte d'une seconde couche de résine photosensible 18 comme montré à la figure 13. Cette seconde couche de résine photosensible 18 est ensuite sélectivement insolée par exemple au moyen d'un faisceau laser ou à travers un masque dont les ouvertures correspondent aux zones de la couche de matériau sacrificiel 2 que l'on veut conserver pour créer le motif 20 décoratif ou technique que l'on veut faire apparaître à la surface du substrat 1.

Après insolation, on distingue ainsi dans la couche de résine photosensible 18 des premières zones 18A qui n'ont pas été exposées à l'éclairage sélectif, et des secondes zones 18B qui ont été sélectivement éclairées et qui correspondent aux parties de la couche de matériau sacrificiel 2 et de la couche supplémentaire de finition 8 que l'on doit conserver. La couche de résine photosensible 18 est ensuite développée de façon que les premières zones 18A soient éliminées et que ne subsistent que les secondes zones 18B qui ont été exposées à la lumière comme cela est visible sur la figure 14.

Le substrat 1 est ensuite soumis à une attaque chimique de façon à éliminer les parties de la couche supplémentaire de finition 16 et de la couche de matériau sacrificiel 2 non recouvertes par la résine photosensible. Finalement, comme visible à la figure 15, on obtient un substrat 1 dont certaines zones sont à nu et présentent un aspect poli, tandis que d'autres zones du substrat 1 sont recouvertes de la couche de matériau sacrificiel 2 revêtue de la couche supplémentaire de finition 16 et dans laquelle sont structurées les cavités 4 pour former le motif 20 décoratif ou technique d'aspect satiné ou mat.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. On comprendra notamment que la première couche déposée sur le substrat 1 est appelée couche de matériau sacrificiel 2 car elle est destinée à être éliminée en totalité à l'exception de l'endroit où est structuré le motif 20 décoratif ou technique. C'est pourquoi cette couche de matériau sacrificiel 2 est préférentiellement réalisée en un matériau résistant et peu coûteux. On notera par ailleurs que plus la couche de matériau sacrificiel 2 est épaisse, plus il est aisé d'y structurer les cavités 4. Il faut cependant veiller à ce que cette couche de matériau sacrificiel 2 ne soit pas trop épaisse, au risque qu'apparaissent dans cette couche des contraintes mécaniques internes pouvant occasionner des problèmes de délamination. On notera aussi que le substrat 1 est préférentiellement poli et/ou opaque.

### Nomenclature

1. Substrat
2. Couche de matériau sacrificiel
4. Cavités
6. Bain
8. Couche supplémentaire de finition
10. Couche de résine photosensible
10A. Premières zones
10B. Secondes zones
12. Motif
14. Première couche de résine photosensible
14A. Premières zones
14B. Secondes zones
16. Couche supplémentaire de finition
18. Seconde couche de résine photosensible
18A. Premières zones
18B. Secondes zones
20. Motif

## Revendications

1. Procédé de décoration d'un substrat (1) qui comprend la succession des étapes suivantes :
- se munir du substrat (1) ;
- déposer sur une surface du substrat (1) une couche d'un matériau sacrificiel (2) ;
- structurer la couche de matériau sacrificiel (2) de sorte à créer dans cette couche de matériau sacrificiel (2) une pluralité de cavités (4) pour former un motif (12 ; 20) décoratif ou technique ;
- éliminer la couche de matériau sacrificiel (2) sauf à l'endroit où le motif (12 ; 20) est prévu et dans lequel,
après structuration de la couche de matériau sacrificiel (2) pour y créer les cavités (4), et avant élimination de la couche de matériau sacrificiel (2) sur toute la surface du substrat (1) sauf à l'endroit où le motif (12 ; 20) est prévu, on dépose sur la couche de matériau sacrificiel (2) au moins une couche supplémentaire de finition (8)

2. Procédé de décoration selon la revendication 1, **caractérisé en ce que** la couche supplémentaire de finition (8) est réalisée au moyen d'un ou de plusieurs matériaux métalliques ou bien des oxydes, nitrures, carbures ou carbo-oxynitrures de ces matériaux métalliques.

3. Procédé de décoration selon la revendication 2, **caractérisé en ce que** le ou les matériaux métalliques dans lesquels est réalisée la couche supplémentaire de finition (8) sont sélectionnés dans le groupe formé par le chrome, le zirconium, l'or, le titane et l'aluminium.

4. Procédé de décoration selon l'une des revendications 1 à 3, **caractérisé en ce que** les cavités (4) sont de profondeurs différentes.

5. Procédé de décoration selon l'une des revendications 1 à 4, **caractérisé en ce que** certaines au moins des cavités (4) créées dans la couche de matériau sacrificiel (2) traversent cette couche de matériau sacrificiel (2) jusqu'au substrat (1).

6. Procédé de décoration selon l'une des revendications 1 à 5, **caractérisé en ce que** la couche de matériau sacrificiel (2) est déposée à la surface du substrat (1) par dépôt physique en phase vapeur, par dépôt chimique en phase vapeur ou bien par électrodéposition lorsque le substrat (1) est conducteur de l'électricité.

7. Procédé de décoration selon l'une des revendications 1 à 6, **caractérisé en ce que** la couche de matériau sacrificiel (2) est réalisée au moyen d'un ou de plusieurs matériaux métalliques ou bien des oxydes, nitrures, carbures ou carbo-oxynitrures de ce ou ces matériaux métalliques.

8. Procédé de décoration selon la revendication 7, **caractérisé en ce que** le matériau métallique est choisi dans le groupe formé par le chrome, le zirconium, le titane et l'aluminium.

9. Procédé de décoration selon l'une des revendications 7 et 8, **caractérisé en ce que** la couche de matériau sacrificiel (2) a une épaisseur comprise entre 100 nm et 10 µm.

10. Procédé de décoration selon la revendication 9, **caractérisé en ce que** la couche de matériau sacrificiel (2) a une épaisseur comprise entre 500 nm et 2 µm.

11. Procédé de décoration selon l'une des revendications 1 à 10, **caractérisé en ce que** les cavités (4) dans la couche de matériau sacrificiel (2) sont créées par attaque chimique en voie humide ou en voie sèche, par ablation laser ou bien par photolithographie.

12. Procédé de décoration selon la revendication **11, caractérisé en ce que** l'attaque chimique en voie humide ou en voie sèche affecte toute la surface de la couche de matériau sacrificiel (2) ou bien s'opère à travers les ouvertures d'un masque posé sur la couche de matériau sacrificiel et dont les contours correspondent au motif (12 ; 20) décoratif ou technique que l'on veut faire apparaître dans la couche de matériau sacrificiel (2).

13. Procédé de décoration selon la revendication **11, caractérisé en ce que** la photolithographie consiste à créer les cavités (4) dans la couche de matériau sacrificiel (2) directement par ablation au moyen d'un faisceau laser ou au moyen d'un rayonnement lumineux à travers les ouvertures d'un masque posé sur cette couche de matériau sacrificiel (2) et dont les contours correspondent au motif décoratif ou technique (12 ; 20) que l'on veut faire apparaître dans la couche de matériau sacrificiel.

14. Procédé de décoration selon l'une quelconque des revendications 1 à 13, **caractérisé en ce qu'**après structuration de la couche de matériau sacrificiel (2) et éventuellement dépôt de la couche supplémentaire de finition (8), on effectue les étapes suivantes :
- déposer sur la couche de matériau sacrificiel (2) éventuellement revêtue de la couche supplémentaire de finition (8) une couche d'une résine photosensible (18) ;
- exposer la couche de résine photosensible (18) directement à l'action d'un faisceau laser ou bien à un rayonnement lumineux sélectivement aux endroits correspondant au motif décoratif ou technique (12 ; 20) que l'on veut faire apparaître dans la couche de matériau sacrificiel (2) ;
- éliminer la couche de résine photosensible (18) et la couche de matériau sacrificiel (2) sous-jacente éventuellement recouverte de la couche supplémentaire de finition (8) aux endroits où la couche de résine photosensible (18) n'a pas été exposée ;
- éliminer la couche de résine photosensible (18) qui subsiste aux endroits où la couche de matériau sacrificiel (2) doit être conservée.

15. Procédé de décoration selon l'une des revendications 1 à 14, **caractérisé en ce que** le substrat (1) est un élément d'habillage pour une boîte de montre ou pour un article de bijouterie.

16. Procédé de décoration selon la revendication 15, **caractérisé en ce que** le substrat (1) est un pont, une platine, une lunette, une carrure, une glace, un cadran, un fond ou un maillon de bracelet.

17. Procédé de décoration selon l'une des revendications 15 et 16, **caractérisé en ce que** le substrat (1) présente un aspect poli et/ou opaque.

## Patentansprüche

1. Verfahren für ein Dekorieren eines Substrats (1), umfassend die folgende Schrittfolge:
- Nehmen des Substrats (1);
- Aufbringen einer Schicht aus Opfermaterial (2) auf eine Oberfläche des Substrats (1);
- Strukturieren der Schicht aus Opfermaterial (2), um eine Mehrzahl von Hohlräumen (4) in dieser Schicht aus Opfermaterial (2) zu erzeugen, um ein dekoratives oder technisches Muster (12; 20) zu bilden;
- Entfernen der Schicht aus Opfermaterial (2) mit Ausnahme des Bereichs, in dem das Muster (12; 20) erscheinen soll und in dem,
nach dem Strukturieren der Schicht aus Opfermaterial (2), um darin die Hohlräume (4) zu erzeugen, und vor dem Entfernen der Schicht aus Opfermaterial (2) von der gesamten Oberfläche des Substrats (1) mit Ausnahme des Bereichs, in dem das Muster (12; 20) erscheinen soll, mindestens eine zusätzliche Veredelungsschicht auf die Schicht aus Opfermaterial (2) (8) aufgebracht wird.

2. Dekorationsverfahren nach Anspruch 1, **dadurch gekennzeichnet, dass** die zusätzliche Veredelungsschicht (8) unter Verwendung eines oder mehrerer metallischer Werkstoffe oder unter Verwendung von Oxiden, Nitriden, Carbiden oder Carbooxynitriden dieser metallischen Werkstoffe hergestellt wird.

3. Dekorationsverfahren nach Anspruch 2, **dadurch gekennzeichnet, dass** das metallische Material oder die metallischen Materialien, aus denen die zusätzliche Veredlungsschicht (8) hergestellt wird, aus der Gruppe bestehend aus Chrom, Zirkonium, Gold, Titan und Aluminium ausgewählt wird/werden.

4. Dekorationsverfahren nach einem der Ansprüche 1 bis 3, **dadurch gekennzeichnet, dass** die Hohlräume (4) unterschiedlich tief sind.

5. Dekorationsverfahren nach einem der Ansprüche 1 bis 4, **dadurch gekennzeichnet, dass** mindestens ein Teil der in der Schicht aus Opfermaterial (2) erzeugten Hohlräume (4) durch diese Schicht aus Opfermaterial (2) hindurch zu dem Substrat (1) verläuft.

6. Dekorationsverfahren nach einem der Ansprüche 1 bis 5, **dadurch gekennzeichnet, dass** die Schicht aus Opfermaterial (2) auf der Oberfläche des Substrats (1) durch physikalische Dampfphasenabscheidung, durch chemische Dampfphasenabscheidung oder durch Elektroabscheidung aufgebracht wird, wenn das Substrat (1) elektrisch leitfähig ist.

7. Dekorationsverfahren nach einem der Ansprüche 1 bis 6, **dadurch gekennzeichnet, dass** die Schicht aus Opfermaterial (2) unter Verwendung eines oder mehrerer metallischer Werkstoffe oder unter Verwendung von Oxiden, Nitriden, Carbiden oder Carbooxynitriden dieses metallischen Werkstoffs/dieser metallischen Werkstoffe hergestellt wird.

8. Dekorationsverfahren nach Anspruch 7, **dadurch gekennzeichnet, dass** das metallische Material ausgewählt ist aus der Gruppe bestehend aus Chrom, Zirkonium, Titan und Aluminium.

9. Dekorationsverfahren nach einem der Ansprüche 7 und 8, **dadurch gekennzeichnet, dass** die Schicht aus Opfermaterial (2) eine Dicke aufweist, die zwischen 100 nm und 10 µm umfasst.

10. Dekorationsverfahren nach Anspruch 9, **dadurch gekennzeichnet, dass** die Schicht aus Opfermaterial (2) eine Dicke aufweist, die zwischen 500 nm und 2 µm umfasst.

11. Dekorationsverfahren nach einem der Ansprüche 1 bis 10, **dadurch gekennzeichnet, dass** die Hohlräume (4) in der Schicht aus Opfermaterial (2) durch nass- oder trockenchemisches Ätzen, durch Laserablation oder durch Fotolithographie erzeugt werden.

12. Dekorationsverfahren nach Anspruch 11, **dadurch gekennzeichnet, dass** das nass- oder trockenchemische Ätzen die gesamte Oberfläche der Schicht des Opfermaterials (2) betrifft oder durch die Öffnungen einer auf der Schicht des Opfermaterials angebrachten Maske durchgeführt wird, und wobei die Umrisse dem dekorativen oder technischen Muster (12; 20) entsprechen, das auf die Schicht des Opfermaterials (2) aufzubringen ist.

13. Dekorationsverfahren nach Anspruch 11, **dadurch gekennzeichnet, dass** die Fotolithografie darin besteht, die Hohlräume (4) direkt in der Schicht aus Opfermaterial (2) durch Ablation unter Verwendung eines Laserstrahls oder durch Lichtstrahlung durch die Öffnungen einer auf dieser Schicht aus Opfermaterial (2) angebrachten Maske zu erzeugen, und wobei die Umrisse dem dekorativen oder technischen Muster (12; 20) entsprechen, das in der Schicht aus Opfermaterial erscheinen soll.

14. Dekorationsverfahren nach einem der Ansprüche 1 bis 13, **dadurch gekennzeichnet, dass** nach dem Strukturieren der Schicht aus Opfermaterial (2) und dem optionalen Aufbringen der zusätzlichen Veredelungsschicht (8) die folgenden Schritte durchgeführt werden:
- Aufbringen einer Schicht eines lichtempfindlichen Harzes (18) auf die Schicht aus Opfermaterial (2), die optional mit der zusätzlichen Veredelungsschicht (8) beschichtet ist;
- Aussetzen der Schicht aus lichtempfindlichem Harz (18) einer direkten Einwirkung eines Laserstrahls oder einer Lichtstrahlung selektiv an den Punkten, die dem dekorativen oder technischen Muster (12; 20) entsprechen, das in der Schicht aus Opfermaterial (2) erscheinen soll;
- Entfernen der Schicht aus lichtempfindlichem Harz (18) und der darunter liegenden Schicht aus Opfermaterial (2), die optional mit der zusätzlichen Veredelungsschicht (8) bedeckt ist, von den Bereichen, in denen die Schicht aus lichtempfindlichem Harz (18) nicht belichtet wurde;
- Entfernen der verbleibenden Schicht des lichtempfindlichen Harzes (18) von den Bereichen, in denen die Schicht des Opfermaterials (2) beizubehalten ist.

15. Dekorationsverfahren nach einem der Ansprüche 1 bis 14, **dadurch gekennzeichnet, dass** das Substrat (1) ein Außenteil für ein Uhrengehäuse oder für ein Schmuckstück ist.

16. Dekorationsverfahren nach Anspruch 15, **dadurch gekennzeichnet, dass** das Substrat (1) ein Steg, eine Platte, eine Fassung, ein Mittelteil, ein Glas, ein Zifferblatt, eine Rückseite oder ein Glied eines Armbandes ist.

17. Dekorationsverfahren nach einem der Ansprüche 15 und 16, **dadurch gekennzeichnet, dass** das Substrat (1) ein poliertes und/oder undurchsichtiges Erscheinungsbild aufweist.

## Claims

1. A method for decorating a substrate (1) comprising the following sequence of steps:
- take the substrate (1);
- deposit a layer of sacrificial material (2) on a surface of the substrate (1);
- structure the layer of sacrificial material (2) so as to create a plurality of cavities (4) in this layer of sacrificial material (2) to form a decorative or technical pattern (12; 20);
- remove the layer of sacrificial material (2) except for the area where the pattern (12; 20) is to appear and in which,
after structuring the layer of sacrificial material (2) to create the cavities (4) therein, and before removing the layer of sacrificial material (2) from the entire surface of the substrate (1) except for the area where the pattern (12; 20) is to appear, at least one supplementary finishing layer is deposited on the layer of sacrificial material (2) (8)

2. The decoration method according to claim 1, **characterised in that** the supplementary finishing layer (8) is produced using one or more metallic materials or using oxides, nitrides, carbides or carbo-oxynitrides of these metallic materials.

3. The decoration method according to claim 2, **characterised in that** the metallic material or materials in which the supplementary finishing layer (8) is produced are chosen from the group formed by chromium, zirconium, gold, titanium and aluminium.

4. The decoration method according to any of claims 1 to 3, **characterised in that** the cavities (4) are of different depths.

5. The decoration method according to any of claims 1 to 4, **characterised in that** at least some of the cavities (4) created in the layer of sacrificial material (2) pass through this layer of sacrificial material (2) to the substrate (1).

6. The decoration method according to any of claims 1 to 5, **characterised in that** the layer of sacrificial material (2) is deposited on the surface of the substrate (1) by physical vapour phase deposition, by chemical vapour phase deposition or by electrodeposition if the substrate (1) is electrically conductive.

7. The decoration method according to any of claims 1 to 6, **characterised in that** the layer of sacrificial material (2) is produced using one or more metallic materials or using oxides, nitrides, carbides or carbo-oxynitrides of this or these metallic material(s).

8. The decoration method according to claim 7, **characterised in that** the metallic material is selected from the group formed by chromium, zirconium, titanium and aluminium.

9. The decoration method according to any of claims 7 and 8, **characterised in that** the layer of sacrificial material (2) has a thickness comprised between 100 nm and 10 pm.

10. The decoration method according to claim 9, **characterised in that** the layer of sacrificial material (2) has a thickness comprised between 500 nm and 2 pm.

11. The decoration method according to any of claims 1 to 10, **characterised in that** the cavities (4) in the layer of sacrificial material (2) are created by wet or dry chemical etching, by laser ablation or by photolithography.

12. The decoration method according to claim 11, **characterised in that** the wet or dry chemical etching affects the entire surface of the layer of sacrificial material (2) or is carried out through the openings in a mask placed on the layer of sacrificial material, and in which the outlines correspond to the decorative or technical pattern (12; 20) to be applied to the layer of sacrificial material (2).

13. The decoration method according to claim 11, **characterised in that** the photolithography consists of creating the cavities (4) directly in the layer of sacrificial material (2) by ablation using a laser beam or by luminous radiation through the openings in a mask placed on this layer of sacrificial material (2), and in which the outlines correspond to the decorative or technical pattern (12; 20) that is to appear in the layer of sacrificial material.

14. The decoration method according to any of claims 1 to 13, **characterised in that** after structuring the layer of sacrificial material (2) and optionally depositing the supplementary finishing layer (8), the following steps are carried out:
- deposit a layer of a photosensitive resin (18) on the layer of sacrificial material (2) optionally coated with the supplementary finishing layer (8);
- expose the layer of photosensitive resin (18) directly to the action of a laser beam or to luminous radiation selectively at the points corresponding to the decorative or technical pattern (12; 20) that is to appear in the layer of sacrificial material (2);
- remove the layer of photosensitive resin (18) and the underlying layer of sacrificial material (2), optionally covered by the supplementary finishing layer (8), from the areas where the layer of photosensitive resin (18) has not been exposed;
- remove the remaining layer of photosensitive resin (18) from the areas where the layer of sacrificial material (2) is to be kept.

15. The decoration method according to any of claims 1 to 14, **characterised in that** the substrate (1) is an external part for a watchcase or for a piece of jewellery.

16. The decoration method according to claim 15, **characterised in that** the substrate (1) is a bar, a plate, a bezel, a middle, a glass, a dial, a back or a link on a wristlet.

17. The decoration method according to any of claims 15 and 16, **characterised in that** the substrate (1) has a polished and/or opaque appearance.
